# EUROPÄISCHE PATENTSCHRIFT

(11) **EP 3 751 621 B1**
(45) Veröffentlichungstag und Bekanntmachung des Hinweises auf die Patenterteilung: **07.06.2023**
(21) Anmeldenummer: 20174565.0
(22) Anmeldetag: 11.01.2016
(51) Int. Cl.: H01L 29/778, H01L 29/06, H01L 29/12, H01L 39/14

(54) **VORRICHTUNG ZUR FÜHRUNG VON LADUNGSTRÄGERN UND DEREN VERWENDUNG**
DEVICE FOR GUIDING CHARGE CARRIERS, AND ITS USE
DISPOSITIF DE GUIDAGE DE PORTEURS DE CHARGES ET SON UTILISATION

(30) Priorität: 12.01.2015 EP 15000040
(43) Veröffentlichungstag der Anmeldung: 16.12.2020
(62) Teilanmeldung aus: 16701091.7
(73) Patentinhaber: Weidlich, Helmut, 53572 Unkel (DE)
(72) Erfinder: Weidlich, Helmut, 53572 Unkel (DE)
(74) Vertreter: Häckel, Stefan

(56) Entgegenhaltungen:
- DE-A1- 3 903 919
- Chuan-Kui Wang: "Quantum bound states in a ballistic quantum channel with a multiple double-bend discontinuity Quantum bound states in a ballistic quantum channel with a multiple dou ble-bend discontinuity", Semicond. Sci. Technol. Semicond. Sci. Technol, 1. Januar 1995 (1995-01-01), Seiten 1131-1138, XP055196967, Gefunden im Internet: URL:http://iopscience.iop.org/0268-1242/10 /8/014/pdf/0268-1242_10_8_014.pdf [gefunden am 2015-06-19]
- CHUAN-KUI WANG ET AL: "Quantum bound states in a double-bend quantum channel", JOURNAL OF APPLIED PHYSICS, Bd. 77, Nr. 6, 1. Januar 1995 (1995-01-01) , Seiten 2564-2571, XP055196902, US ISSN: 0021-8979, DOI: 10.1063/1.358718
- MASAHIRO NII ET AL: "Paper;Three-dimensional model for numerical electromagnetic field analyses of coated superconductors and its application to Roebel cables;Three-dimensional model for numerical electromagnetic field analyses of coated superconductors and its application to Roebel cables", SUPERCONDUCTOR SCIENCE AND TECHNOLOGY, IOP PUBLISHING, TECHNO HOUSE, BRISTOL, GB, Bd. 25, Nr. 9, 6. Juli 2012 (2012-07-06), Seite 95011, XP020228499, ISSN: 0953-2048, DOI: 10.1088/0953-2048/25/9/095011

## Beschreibung

Die vorliegende Erfindung betrifft eine Vorrichtung zur Führung von Trägern, die jeweils eine elektrische Ladung und/oder ein magnetisches Moment aufweisen, insbesondere von Ladungsträgern, besonders bevorzugt von Elektronen, sowie Verwendungen der Vorrichtung.

Für die ganz überwiegende Zahl aller Gegenstände der realen Welt, bei denen sich Gruppen bzw. Ensembles von Teilchen (z. B. Gasmoleküle in einem Volumen, Elektronen in einem Festkörper, etc.) bewegen, unterliegen diese Teilchen dem sogenannten Ergodentheorem. Dies bedeutet, dass bei genügend lang andauernder Betrachtung, theoretisch jeder mögliche Punkt im Phasenraum (aus Raum- und Impulskoordinaten) dieses Systems mit gleicher Häufigkeit erreicht wird. Für solche Systeme gelten die Gesetze der Thermodynamik, insbesondere der erste und der zweite Hauptsatz der Wärmelehre.

Nicht-ergodische Systeme sind bisher primär nur theoretisch bekannt. Zum Beispiel stellt ein Billardtisch mit ideal parallelen Wänden und eine reibungsfrei rollende Kugel ein solches nicht-ergodisches System dar, wenn die Kugel von der Mitte des Tisches aus genau senkrecht zu einer der Begrenzungswände eingeworfen wird und an den Begrenzungswänden ideal senkrecht zur Wand reflektiert wird. In diesem Fall würde die Kugel immer nur auf der Verbindungslinie zwischen den beiden ideal parallelen Wänden hin- und herrollen, aber nie die anderen Bereiche des Billardtischs erreichen.

Bei dem genannten Beispiel sind die Voraussetzungen für das Zustandekommen des nicht-ergodischen Systems erheblich, nämlich die Form der Begrenzungswände muss ideal parallel sein, die Form der Teilchenbahn (Kugel) muss ideal gerade sein, die Reflektion an den Wänden muss ideal senkrecht erfolgen, die Anfangsbewegungsrichtung muss ideal senkrecht zur Wand sein und es darf keine Streuung auf der Bahn ohne Kontakt zu Begrenzungswänden auftreten. Derartige Voraussetzungen sind in der Praxis selten realisierbar.

Die vorliegende Erfindung befasst sich mit solchen nicht-ergodischen Systemen, wobei mögliche Realisierungen und Anwendungen aufgezeigt werden.

Die DE 39 03 919 A1 offenbart eine Vorrichtung und ein Verfahren zur Führung von Elektronen in einem Festkörper, wobei auf eine sphärisch gekrümmte Oberfläche eines elektrischen Isolierstoffs eine dünne Halbleiterschicht aufgebracht wird. Mittels eines Magnetfelds wird der Bahnkrümmungsradius der Elektronen in der Schicht auf die gleiche oder eine benachbarte Größenordnung wie der Schichtkrümmungsradius gebracht. Zwischen zwei beabstandeten Stellen der gekrümmten Schicht wird eine Potentialdifferenz abgegriffen. Die Dimensionen, insbesondere die Dicke der Halbleiterschicht, müssen in der Größenordnung der mittleren freien Weglänge der Elektronen in der Halbleiterschicht liegen, die in einer homogenen Halbleiterschicht sehr klein sind, so dass eine Realisierung schwierig ist.

Die Aufsätze "Quantum bound states in a ballistic quantum channel with a multiple double-bend discontinuity von Chuan-Kui Wang, Semicond. Sci. Technol., 1. Januar 1995, Seiten 1131-1138, und "Quantum bound states in a double-bend quantum channel" von Chuan-Kui Wang et al., Journal of Applied Physics, Bd. 77, Nr. 6, 1. Januar 1995, Seiten 2564-2571, befassen sich mit Quantenzuständen eines Elektronengases in einem schmalen Kanal mit entgegengesetzt doppelt gebogener Diskontinuität ohne Einwirkung eines externen Feldes und ohne Untersuchung richtungsabhängiger Leitfähigkeiten. Weiter muss die Kanalbreite deutlich unter der De Broglie-Wellenlänge der Elektronen liegen, um das gewünschte quantenmechanische Verhalten zu realisieren.

Der vorliegenden Erfindung liegt die Aufgabe zugrunde, eine Vorrichtung zur Führung von Trägern, die jeweils eine elektrische Ladung und/oder ein magnetisches Moment aufweisen, insbesondere von Ladungsträgern, besonders bevorzugt von Elektronen, sowie Verwendungen solcher Vorrichtungen anzugeben, wobei ein einfacher Aufbau und eine einfache Herstellung ermöglicht werden und verschiedene Einsatzmöglichkeiten angegeben werden.

Die obige Aufgabe wird durch eine Vorrichtung gemäß Anspruch 1 oder durch eine Verwendung gemäß einem der Ansprüche 8 bis 12 gelöst. Vorteilhafte Weiterbildungen sind Gegenstand der Unteransprüche.

Gemäß einem ersten Aspekt der vorliegenden Erfindung weist die Vorrichtung vorzugsweise eine Leiteinrichtung auf, die ein zweidimensionales Elektronengas oder eine dünne, supraleitende Schicht zur Bildung eines Bewegungsbereichs für die beweglichen Träger aufweist oder bildet. In diesen zweidimensionalen Elektronengasen oder supraleitenden Schichten herrschen nämlich vergleichsweise große mittlere freie Weglängen insbesondere für Elektronen vor. Dies ermöglicht auf sehr einfache Weise die Realisierung des gewünschten Bewegungsbereichs. Die Breite des Bewegungsbereichs und sein Krümmungsradius liegen insbesondere in der Größenordnung der mittleren freien Weglänge, aber noch oberhalb der De Broglie-Wellenlänge der Träger bzw. Elektronen im Bewegungsbereich. Diese Dimensionierung ist besonders vorteilhaft zur Erzeugung des gewünschten, nicht-ergodischen Systems für die Träger.

Die Träger bewegen sich in der Leiteinrichtung bzw. in dem Bewegungsbereich mit einer mittleren Geschwindigkeit, die auch von der thermischen Energie abhängt.

Der Bewegungsbereich bildet bzw. umgrenzt einen gekrümmten oder abgewinkelten Hauptweg für die Träger. Durch eine Felderzeugungseinrichtung ist ein Feld, insbesondere Magnetfeld, zur Führung der Träger zumindest im Wesentlichen entlang des Hauptwegs erzeugbar. Dementsprechend können sich die Träger zumindest im Wesentlichen frei, also quasi unter Vermeidung oder unter Minimierung von Stößen, in eine Richtung, zumindest im Wesentlichen entlang des Hauptwegs oder parallel dazu bewegen. In der entgegengesetzten Richtung werden die Träger jedoch abgelenkt, insbesondere in Richtung seitlicher Flanken des Bewegungsbereichs. Dementsprechend ergibt sich in der entgegengesetzten Richtung eine wesentlich höhere Anzahl von Stößen und von Reflektionen an Grenzflächen. Dies führt insbesondere auch aufgrund des Vorkommens von zumindest teilweise nicht streng spiegelnden bzw. aufgrund von vorzugsweise diffus streuenden Wandstößen zu einer Ungleichverteilung der Träger, so dass im Bereich des Anfangs und Endes des Hauptwegs bzw. entlang des Hauptwegs eine unterschiedliche Aufenthaltswahrscheinlichkeit bzw. -dichte der Träger resultiert. Insbesondere wird vorschlagsgemäß eine richtungsabhängig unterschiedliche Leitfähigkeit erzeugt, vorzugsweise wobei die Leitfähigkeit entlang dem Hauptweg größer als die Leitfähigkeit in die entgegensetzte Richtung ist.

Bei dem Hauptweg handelt es sich insbesondere zumindest im Wesentlichen um einen Haupterstreckungsverlauf des Bewegungsbereichs und/oder um einen Bewegungsweg, dem ein Träger in einer Richtung im Bewegungsbereich bei Vernachlässigung von Stößen unter Berücksichtigung des einwirkenden Feldes im Idealfall folgt. Der Hauptweg liegt insbesondere also in der Hauptebene des Bewegungsbereichs und innerhalb des Bewegungsbereichs, vorzugsweise zumindest im Wesentlichen entlang einer (ab)gebogenen Mittellinie des Bewegungsbereichs.

Die Träger tragen vorzugsweise jeweils eine elektrische Ladung, insbesondere handelt es sich um Elektronen oder alternativ um sogenannte Löcher bzw. Elektronenfehlstellen. Dementsprechend können bzw. kann aufgrund der unterschiedlichen Aufenthaltswahrscheinlichkeit bzw. -dichte der Träger über entsprechend entlang des Hauptwegs angeordnete elektrische Anschlüsse eine elektrische Spannung, ein elektrischer Strom und/oder eine elektrische Leistung abgegriffen werden. Dies hat sich durch Versuche bestätigt.

Grundsätzlich ist es auch möglich, dass die Träger jeweils ein magnetisches Moment aufweisen und mit einem elektrischen und/oder magnetischen Feld wechselwirken.

Gemäß einem anderen, auch unabhängig realisierbaren Aspekt der vorliegenden Erfindung erstreckt sich die Leiteinrichtung bzw. der Bewegungsbereich vorzugsweise zumindest im Wesentlichen entlang einer geschlossenen ebenen oder sphärischen Fläche bzw. in einer Ebene und ist in dieser Fläche bzw. Ebene gekrümmt bzw. abgewinkelt. Dies ermöglicht auf relativ einfache Weise, insbesondere durch planare Schichten, den Aufbau und die Herstellung einer vorschlagsgemäßen Vorrichtung, auch in sehr kleinen Dimensionen, vorzugsweise mit einem mittleren Krümmungsradius des Hauptwegs von weniger als 2000 nm und/oder mit einer mittleren Breite der Leiteinrichtung bzw. Bewegungsbereichs von weniger als 2000 nm.

Gemäß einem weiteren, unabhängigen Aspekt der vorliegenden Erfindung ist die vorschlagsgemäße Vorrichtung zum Erzeugen einer elektrischen Spannung, insbesondere Gleichspannung, und Leistung aus der thermischen Energie bzw. Wärmeenergie von Ladungsträgern und/oder aus dem elektromagnetischen Eigen- oder Umgebungsrauschen bzw. aus elektromagnetischer Einwirkung oder Einstrahlung einsetzbar, indem die Spannung oder Leistung über die Anschlüsse abgegriffen wird.

Vorzugsweise wird hierbei das Feld bzw. Magnetfeld zur Führung der Ladungsträger zumindest im Wesentlichen konstant gehalten. Alternativ oder zusätzlich kann auch eine Steuerung oder Regelung des Felds bzw. Magnetfelds dahingehend erfolgen, dass die abgegriffene Spannung oder elektrische Leistung auf einem Sollwert oder Maximalwert gehalten wird.

Ein anderer Aspekt der vorliegenden Erfindung liegt darin, dass die vorschlagsgemäße Vorrichtung zum Kühlen durch Entzug von Wärmeenergie von Ladungsträgern einsetzbar ist, indem elektrische Leistung über die Anschlüsse abgegriffen wird. Dies ist sehr einfach realisierbar und grundsätzlich für verschiedenste Zwecke einsetzbar.

Vorzugsweise wird hierbei das Feld bzw. Magnetfeld zur Führung der Ladungsträger zumindest im Wesentlichen konstant gehalten. Alternativ oder zusätzlich kann auch eine Steuerung oder Regelung des Felds bzw. Magnetfelds dahingehend erfolgen, dass die abgegriffene elektrische Spannung oder Leistung auf einem Sollwert oder Maximalwert gehalten wird.

Gemäß einem anderen Aspekt der vorliegenden Erfindung kann die vorschlagsgemäße Vorrichtung auch zum Messen oder Erfassen von elektromagnetischem Eigen- oder Umgebungsrauschen von Ladungsträgern bzw. von elektromagnetischer Einstrahlung eingesetzt werden, indem eine elektrische Spannung über die Anschlüsse gemessen wird. Durch die Messung der Spannung kann dann das Rauschen bzw. die elektromagnetische Einstrahlung erfasst bzw. bestimmt werden.

Insbesondere wird bei der vorgenannten Messung das Feld bzw. Magnetfeld oder die einwirkende Magnetfeldstärke zumindest im Wesentlichen konstant gehalten. Bei entsprechender Kalibrierung ist dann die Erfassung oder Bestimmung des Rauschens bzw. einer einwirkenden elektromagnetischen Strahlung sehr einfach möglich. Jedoch kann grundsätzlich auch das Feld bzw. Magnetfeld zur Führung der Träger variiert werden.

Gemäß einem weiteren Aspekt der vorliegenden Erfindung ist die vorschlagsgemäße Vorrichtung zum Messen oder Bestimmen von Streuungen oder Bewegungsbahnen von Ladungsträgern einsetzbar, indem eine elektrische Spannung über die Anschlüsse gemessen wird. Die gemessene Spannung kann insbesondere Informationen über Zustände der Leiteinrichtung bzw. im Bewegungsraum geben.

Generell kann die vorschlagsgemäße Vorrichtung zum Messen oder Bestimmen von physikalischen Eigenschaften innerhalb eines ein- oder zweidimensionalen Elektronengases oder Supraleiters eingesetzt werden.

Bei dem Messen oder Bestimmen von Streuungen, Bewegungsbahn und/oder (sonstigen) physikalischen Eigenschaften kann das die Ladungsträger führende Feld bzw. Magnetfeld je nach Bedarf zumindest im Wesentlichen konstant gehalten und/oder zeitlich und/oder räumlich variiert werden. Bei entsprechender Kalibrierung sind unter Berücksichtigung der gemessenen Spannungen die gewünschten Messungen bzw. Bestimmungen sehr einfach möglich.

Außerdem ist es möglich, die Vorrichtung ohne Felderzeugungseinrichtung zum Messen von auf die Leiteinrichtung einwirkenden Magnetfeldstärken einzusetzen, indem die elektrische Spannung über die Anschlüsse gemessen wird. Insbesondere bei vorheriger Kalibrierung ist so eine Messung von Magnetfeldstärken möglich.

Einzelne der vorgenannten und nachfolgenden Aspekte und Merkmale der vorliegenden Erfindung können beliebig miteinander kombiniert, aber auch unabhängig voneinander realisiert werden.

Weitere Aspekte, Merkmale, Vorteile und Eigenschaften der vorliegenden Erfindung ergeben sich aus den Ansprüchen und der nachfolgenden Beschreibung bevorzugter Ausführungsformen anhand der Zeichnung. Es zeigt:
- Fig. 1: eine perspektivische Ansicht einer vorschlagsgemäßen Vorrichtung, jedoch ohne Felderzeugungseinrichtung, gemäß einer ersten Ausführungsform;
- Fig. 2: eine schematische Seitenansicht der Vorrichtung mit Felderzeugungseinrichtung;
- Fig. 3: eine schematische Draufsicht der Vorrichtung ohne Felderzeugungseinrichtung;
- Fig. 4: eine perspektivische Ansicht einer vorschlagsgemäßen Vorrichtung gemäß einer zweiten Ausführungsform;
- Fig. 5: eine schematische Draufsicht einer vorschlagsgemäßen Vorrichtung gemäß einer dritten Ausführungsform;
- Fig. 6: ein Spannungsdiagramm gemessen an der Vorrichtung gemäß der dritten Ausführungsform;
- Fig. 7: ein Stromdiagramm gemessen an der Vorrichtung gemäß der dritten Ausführungsform;
- Fig. 8: ein Diagramm einer gemessenen Strom-Spannungskennlinie, also ein Diagramm der abgreifbaren elektrischen Leistung;
- Fig. 9: ein Diagramm verschiedener Strom-Kennlinien; und
- Fig. 10: eine perspektivische Ansicht einer vorschlagsgemäßen Vorrichtung gemäß einer fünften Ausführungsform in einer zu Fig. 1 korrespondierenden Darstellung.

In den Figuren werden für gleiche oder gleichartige Komponenten und Einrichtungen die gleichen Bezugszeichen verwendet, wobei sich die gleichen oder entsprechenden Vorteile und Eigenschaften ergeben, auch wenn eine wiederholte Beschreibung weggelassen ist.

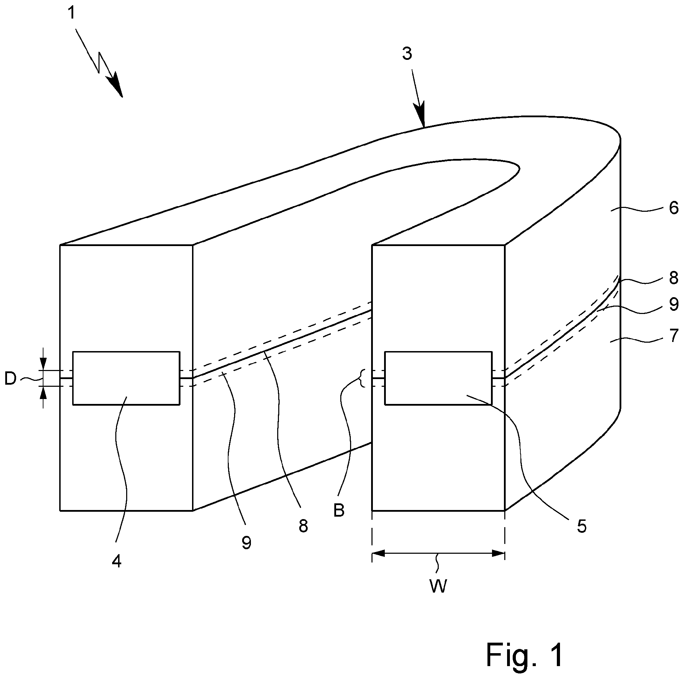

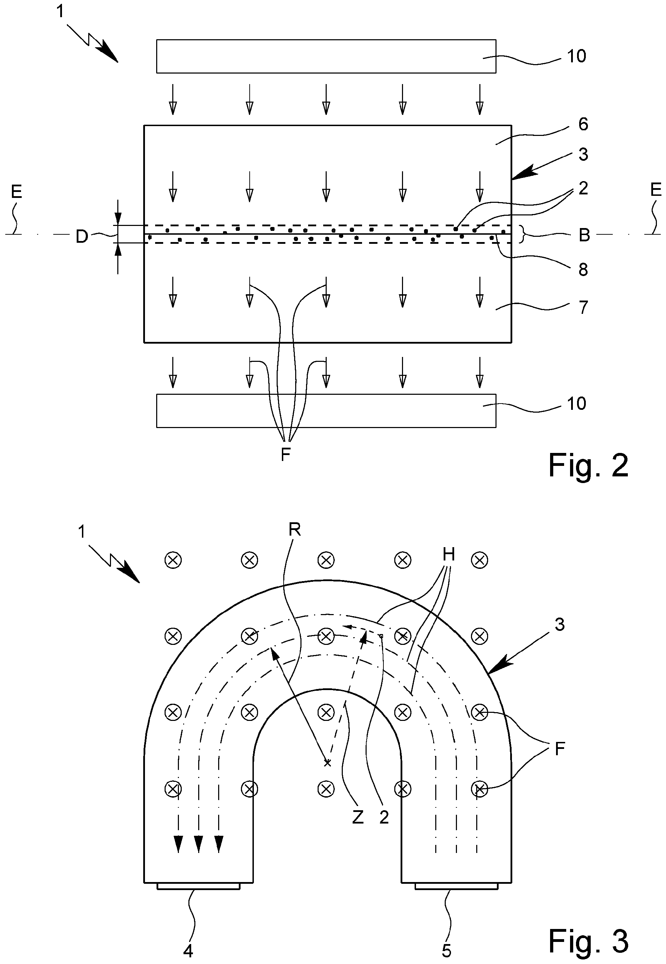

Fig. 1 zeigt in einer sehr schematischen, perspektivischen Ansicht eine vorschlagsgemäße Vorrichtung 1 gemäß einer ersten Ausführungsform. Fig. 2 zeigt die Vorrichtung 1 in einer schematischen Seitenansicht mit zugeordneter Felderzeugungseinrichtung 10. Fig. 3 zeigt die Vorrichtung 1 in einer schematischen Draufsicht, ohne die Felderzeugungseinrichtung 10.

Die Vorrichtung 1 dient der Führung von Trägern 2 (in Fig. 2 schematisch angedeutet), die jeweils eine elektrische Ladung und/oder ein magnetisches Moment aufweisen. Bei den Trägern 2 handelt es sich insbesondere um Ladungsträger, besonders bevorzugt um Elektronen. Jedoch kann es sich beispielsweise auch um sogenannte Löcher, also Elektronenfehlstellen, handeln.

Die Vorrichtung 1 weist eine Leiteinrichtung 3 zur beweglichen Führung der Träger 2 auf. Bei der Leiteinrichtung 3 handelt es sich insbesondere um einen Festkörper oder Festkörperaufbau. Die Träger 2 sind also insbesondere in einem Festkörper oder Festkörperaufbau beweglich.

Vorzugsweise sind die Träger 2 zumindest im Wesentlichen nur in einem - insbesondere flachen und/oder flächigen - Bewegungsbereich B beweglich, wie in Fig. 2 angedeutet.

Die Vorrichtung 1 bzw. Leiteinrichtung 3 ist vorzugsweise mit elektrischen Anschlüssen 4 und 5 versehen, die in Fig. 1 und 3 angedeutet sind.

Die Vorrichtung 1 bzw. Leiteinrichtung 3 ist beim Darstellungsbeispiel vorzugsweise aus einem ersten Festkörper bzw. Halbleiter 6 und aus einem zweiten Festkörper bzw. Halbleiter 7 aufgebaut. Diese sind flächig übereinander angeordnet und/oder weisen eine gemeinsame Grenzfläche 8 auf.

Die Kontakt- bzw. Grenzfläche 8 der beiden Festkörper bzw. Halbleiter 6, 7 bzw. der Bewegungsbereich B ist vorzugsweise zumindest im Wesentlichen eben ausgebildet und/oder erstreckt sich vorzugsweise zumindest im Wesentlichen entlang einer geschlossenen - insbesondere ebenen oder sphärischen - Fläche und/oder in einer Ebene E, wie in Fig. 2 angedeutet.

Die aufeinanderliegenden Schichten bzw. Festkörper 6, 7 bilden vorzugsweise ein zweidimensionales Elektronengas für die Träger 2. Im Sinne der Festkörperphysik handelt es sich bei dem Elektronengas um frei bewegliche Träger 2 in Form von Elektronen oder Fehlstellen im Leitungsband, insbesondere mit einer großen mittleren freien Weglänge von vorzugsweise mehr als 100 nm, insbesondere mehr als 200 nm. Diese besonders leitfähige Zone bildet sich vorzugsweise nur auf beiden Seiten der Grenzfläche 8, also in Form einer sehr dünnen Schicht, die den Bewegungsraum B für die Träger 2 bildet.

Wie bereits erwähnt, kann es sich anstelle von Elektronen beispielsweise auch um sogenannte Löcher, also Elektronenfehlstellen, handeln, die sich als Ladungsträger zumindest weitgehend frei und insbesondere mit großer mittlerer freier Weglänge im Bewegungsbereich B bewegen können.

Die Leiteinrichtung 3 bzw. der Bewegungsbereich B bildet vorzugsweise einen gekrümmten oder abgewinkelten Hauptweg H für die Träger 2, wobei in Fig. 3 mehrere parallel verlaufende Hauptwege H schematisch angedeutet sind.

Die Leiteinrichtung 3 bzw. der Bewegungsbereich B bzw. der Hauptweg H ist vorzugsweise bogenförmig, insbesondere halbkreisförmig oder hufeisenförmig, gekrümmt ausgebildet. Jedoch kann die Leiteinrichtung 3 bzw. der Bewegungsbereich B bzw. der Hauptweg H alternativ oder zusätzlich auch einfach oder mehrfach abgewinkelt sein.

Besonders bevorzugt erstreckt sich die Leiteinrichtung 3 bzw. der Bewegungsbereich B bzw. der Hauptweg H zumindest im Wesentlichen in einer Fläche bzw. Ebene E, ganz besonders bevorzugt hier der Ebene E der Grenzfläche 8, und ist in dieser Fläche bzw. Ebene E gekrümmt bzw. abgewinkelt. Dies ist einer sehr einfachen Realisierung und Herstellung zuträglich, insbesondere beim Aufbringen sehr dünner Schichten mit definierter Dicke.

Die Anschlüsse 4 und 5 sind vorzugsweise entlang des Hauptwegs H angeordnet bzw. voneinander beabstandet, insbesondere im Bereich der Enden des Bogens oder der Abwinklung der Leiteinrichtung 3 bzw. des Bewegungsbereichs B angeordnet.

Der Bewegungsbereich B ist vorzugsweise schichtartig und/oder mehrschichtig ausgebildet. Der Bewegungsbereich B bzw. die jeweilige Schicht weist vorzugsweise eine mittlere Dicke D von weniger als 500 nm, insbesondere weniger als 300 nm, besonders bevorzugt etwa 200 nm oder weniger, auf.

Die mittlere Breite W des Bewegungsbereichs B und der Krümmungsradius R des Hauptwegs H entspricht bzw. entsprechen zumindest im Wesentlichen der mittleren freien Weglänge der Träger 2 im Bewegungsbereich B oder ist bzw. sind vorzugsweise kleiner.

Der (mittlere) Krümmungsradius R der Leiteinrichtung 3 bzw. des Bewegungsbereichs B oder Hauptwegs H beträgt vorzugsweise mehr als 100 nm, insbesondere mehr als 200 nm, und/oder weniger als 2000 nm, insbesondere weniger als 1600 nm.

Die mittlere Breite W des Bewegungsbereichs B beträgt vorzugsweise mehr als 80 nm, insbesondere mehr als 100 nm, und/oder weniger als der (mittlere) Krümmungsradius R.

Die Grenzflächen des Bewegungsbereichs B sind vorzugsweise derart ausgebildet, dass die Träger 2 reflektiert werden, dies kann grundsätzlich spiegelnd (der Reflektionswinkel entspricht zumindest im Wesentlichen dem Einfallswinkel) oder nicht spiegelnd, also insbesondere diffus streuend, erfolgen.

Besonders bevorzugt werden die Träger 2 insbesondere an seitlichen Flanken 9 des Bewegungsbereichs B reflektiert. Dies erfolgt vorzugsweise diffus streuend bzw. zumindest teilweise nicht spiegelnd.

Die Vorrichtung 1 weist vorzugsweise die Felderzeugungseinrichtung 10 auf. Alternativ kann diese oder das von ihr erzeugte Feld F der Vorrichtung 1 auch nur zugeordnet sein bzw. lediglich auf die Vorrichtung 1 bzw. Leiteinrichtung 3 bzw. den Bewegungsbereich B wirken.

Die Felderzeugungseinrichtung 10 dient der Erzeugung bzw. Steuerung eines Felds F zur Führung der Träger 2 zumindest im Wesentlichen entlang des Hauptwegs H, insbesondere so dass an den Anschlüssen 4 und 5 bzw. im Bereich der Enden des bogenförmigen oder abgewinkelten Hauptwegs H eine unterschiedliche Aufenthaltsdichte der Träger 2 erzeugt wird oder erzeugbar ist.

Das Feld F ist in den Fig. 2 und 3 schematisch angedeutet.

Bei dem Feld F handelt es sich insbesondere um ein Magnetfeld. Die Felderzeugungseinrichtung 10 ist also insbesondere zur Erzeugung eines Magnetfelds ausgebildet. Hierzu können grundsätzlich Permanentmagnete eingesetzt werden. Alternativ können jedoch auch Elektromagnete eingesetzt werden, insbesondere um ein elektromagnetisches Feld als Feld F zur Führung der Träger 2 zu erzeugen.

Vorzugsweise ist die Felderzeugungseinrichtung 10 derart ausgebildet, dass das Feld F zur Führung der Träger 2 zumindest im Wesentlichen nur im Bereich der Krümmung oder Abbiegung des Bewegungsbereichs B bzw. der Leiteinrichtung 3 wirkt bzw. die Träger 2 auf gekrümmte Bahnen ablenkt.

Das Feld F zur Führung der Träger 2 bzw. die Felderzeugungseinrichtung 10 ist vorzugsweise derart eingestellt oder anpassbar oder ggf. auch steuerbar oder regelbar, dass die Träger 2 ausgehend von einer mittleren Geschwindigkeit - insbesondere in Abhängigkeit von der mittleren kinetischen Energie bzw. thermischen Energie - durch das Feld F (insbesondere aufgrund der Lorentz-Kraft mit einem Zyklotronradius Z, wie in Fig. 3 schematisch angedeutet) zumindest im Wesentlichen entlang des gekrümmten bzw. abgewinkelten Hauptwegs H und/oder zumindest im Wesentlichen mit dem mittleren Krümmungsradius R in der Leiteinrichtung 3 bzw. im Bewegungsbereich B geführt werden. Dies gilt, wie bereits erwähnt, insbesondere nur für eine Bewegungsrichtung entlang des Hauptwegs H und nicht in der entgegengesetzten Richtung. Diese Asymmetrie ist wichtig im Hinblick auf die vorschlagsgemäß zu erzeugende Ungleichverteilung der Träger 2 im Bewegungsbereich B bzw. entlang des Hauptweges H.

Der durch die Felderzeugungseinrichtung 10 bzw. das Feld F bewirkte Zyklotronradius Z liegt vorzugsweise in der Größenordnung des (mittleren) Krümmungsradius R der Leiteinrichtung 3 bzw. des Bewegungsbereichs B. Besonders bevorzugt ist der Zyklotronradius Z maximal um den Faktor 5, besonders bevorzugt maximal um den Faktor 2, kleiner oder größer als der Krümmungsradius R. Insbesondere entspricht der Zyklotronradius Z zumindest im Wesentlichen dem Krümmungsradius R.

Aufgrund der unterschiedlichen Aufenthaltswahrscheinlichkeiten der Träger 2 im Bereich der Enden des abgewinkelten oder gekrümmten Hauptwegs H können über die insbesondere in diesen Bereichen angeordneten Anschlüsse 4 und 5 eine elektrische Spannung, insbesondere auch ein elektrischer Strom und damit auch eine elektrische Leistung abgegeben bzw. abgegriffen werden.

Beim Darstellungsbeispiel sind die Anschlüsse 4 und 5 insbesondere an den beiden Stirnseiten bzw. Enden des Bewegungsbereichs B bzw. Hauptwegs H und/oder der Leiteinrichtung 3 angeordnet.

Bedarfsweise können auch mehrere Leiteinrichtungen 3 oder Bewegungsbereiche B flachseitig übereinander angeordnet werden. Diese werden dann vorzugsweise von demselben Feld F durchdrungen. Insbesondere können diese wahlweise parallel oder seriell verschaltet, insbesondere mit den Anschlüssen 4 und 5 oder sonstigen Anschlüssen verbunden sein.

Die vorschlagsgemäße Vorrichtung 1 ist insbesondere zum Erzeugen einer elektrischen Spannung oder Leistung aus der thermischen Energie bzw. Wärmeenergie von Trägern 2 und/oder aus dem elektromagnetischen Eigen- oder Umgebungsrauschen bzw. aus elektromagnetischer Einwirkung oder Einstrahlung einsetzbar, indem die Spannung oder Leistung über die Anschlüsse 4 und 5 abgegriffen wird. Hierbei wird vorzugsweise das Feld F zumindest im Wesentlichen konstant gehalten. Alternativ kann das Feld F aber auch gesteuert oder geregelt werden, um bei der abgegriffenen Spannung oder Leistung einen bestimmten Wert zu erreichen oder zu überschreiten oder um ein Maximum zu erreichen.

Alternativ oder zusätzlich ist die vorschlagsgemäße Vorrichtung 1 auch zum Kühlen durch Entzug von thermischer Energie bzw. Wärmeenergie von den Trägern 2 einsetzbar, indem elektrische Leistung über die Anschlüsse 4 und 5 abgegriffen wird. So ist es auch möglich, die Vorrichtung 1 selbst abzukühlen. Dies kann der Leistungsabnahme auch zuträglich sein, also einen selbstverstärkenden Effekt haben.

Beim Kühlen wird vorzugsweise das Feld F zumindest im Wesentlichen konstant gehalten. Alternativ kann das Feld F aber auch gesteuert oder geregelt werden, um bei der abgegriffenen Spannung oder Leistung einen bestimmten Wert zu erreichen oder zu überschreiten oder um ein Maximum zu erreichen.

Weiter ist es möglich, die vorschlagsgemäße Vorrichtung 1 zum Messen oder Bestimmen von Streuungen oder Bewegungsbahnen von Ladungsträgern 2 zu verwenden, in dem die elektrische Spannung über die Anschlüsse 4 und 5 gemessen wird. Insbesondere kann hierbei das einwirkende Feld F variiert und beispielsweise durch Erfassung von Maxima bei der gemessenen elektrischen Spannung auf entsprechende Streuungen oder Bewegungsbahnen von Ladungsträgern 2 geschlossen werden.

Generell kann das vorschlagsgemäße Prinzip auch zum Messen oder Bestimmen von physikalischen Eigenschaften innerhalb eines ein- oder zweidimensionalen Elektronengases oder Supraleiters eingesetzt werden, wenn der Bewegungsbereich B in oder durch ein solches ein- oder zweidimensionales Elektronengas oder einen Supraleiter gebildet wird. Die an entsprechenden Anschlüssen 4 und 5 anliegende Spannung gibt insbesondere in Abhängigkeit von dem wirkenden Feld F bzw. Magnetfeld entsprechend Aufschluss über die physikalischen Eigenschaften.

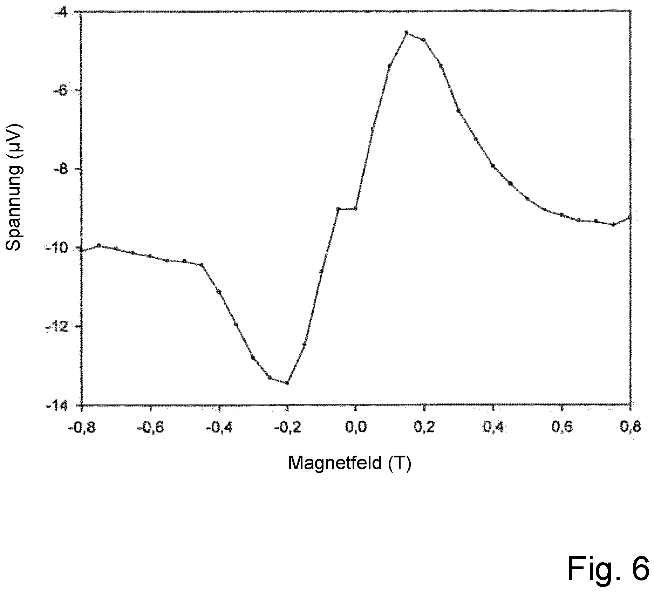

Das vorschlagsgemäße Prinzip kann auch zum Messen bzw. Erfassen von auf die Leiteinrichtung 3 einwirkenden Magnetfeldstärken bzw. sonstigen Feldern F verwendet werden, indem die elektrische Spannung über die Anschlüsse 4 und 5 gemessen wird. Diese hängt nämlich von dem einwirkenden Feld F ab, wie später noch anhand der dritten Ausführungsform und dem diesbezüglichen Diagramm gemäß Fig. 6 näher erläutert. Insbesondere kann bei entsprechender Kalibrierung aus der gemessenen elektrischen Spannung die einwirkende Magnetfeldstärke des Felds F bestimmt werden.

Nachfolgend werden weitere Ausführungsformen der vorliegenden Erfindung bzw. vorschlagsgemäßen Vorrichtung 1 anhand der weiteren Figuren näher erläutert. Die bisherigen Ausführungen, Aspekte und Merkmale gelten insbesondere entsprechend oder ergänzend, auch wenn eine wiederholte Beschreibung weggelassen ist.

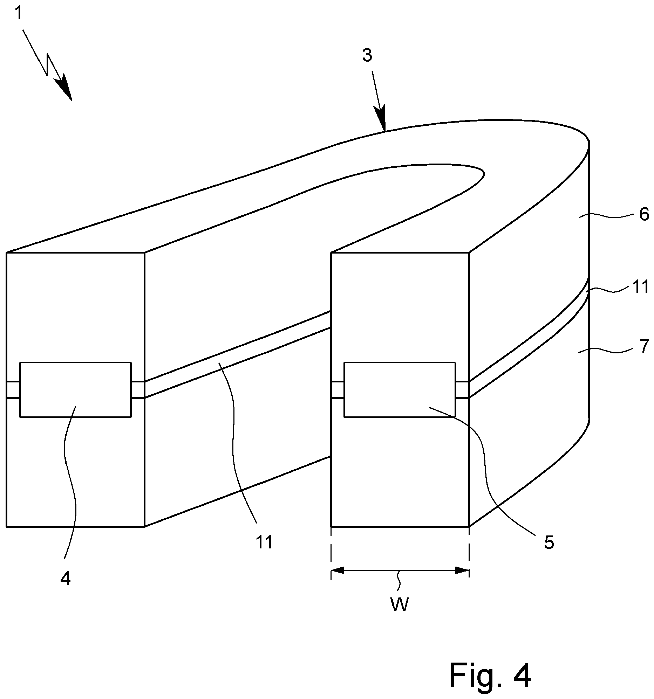

Fig. 4 zeigt in einer zu Fig. 1 korrespondierenden, schematischen Darstellung eine vorschlagsgemäße Vorrichtung 1 gemäß einer zweiten Ausführungsform.

Die zweite Ausführungsform unterscheidet sich von der ersten nur dadurch, dass anstelle eines Elektronengases vorzugsweise eine dünne supraleitende Schicht 11 zur Bildung des Bewegungsbereichs B eingesetzt wird. Die supraleitende Schicht 11 ist vorzugsweise auf oder von dem Festkörper 6 oder 7 bzw. insbesondere zwischen den beiden gebildet oder angeordnet, wie in Fig. 4 angedeutet.

Die Dimensionierung der Schicht 11 bzw. des davon gebildeten Bewegungsbereichs B entspricht vorzugsweise dem bei der ersten Ausführungsform beschriebenen Bewegungsbereich B und dessen Dimensionierung, so dass hierauf verwiesen wird.

In der supraleitenden Schicht 11 liegen die Träger 2 insbesondere als Elektronen oder Löcher, also Elektronenfehlstellen, vor.

Für die Schicht 11 wird insbesondere ein supraleitendes Material der sogenannten zweiten Art bzw. des Typs II eingesetzt, so dass bei höheren Magnetfeldern magnetische Feldlinien in Form sogenannter Flussschläuche in das Material eindringen, wobei hierbei sogenannte harte supraleitende Materialien bevorzugt eingesetzt werden, bei denen die Flussschläuche bis zu einer bestimmten, möglichst hohen Grenzkraft festgehalten werden, so dass diese einen hohen Flux-Flow-Widerstand aufweisen.

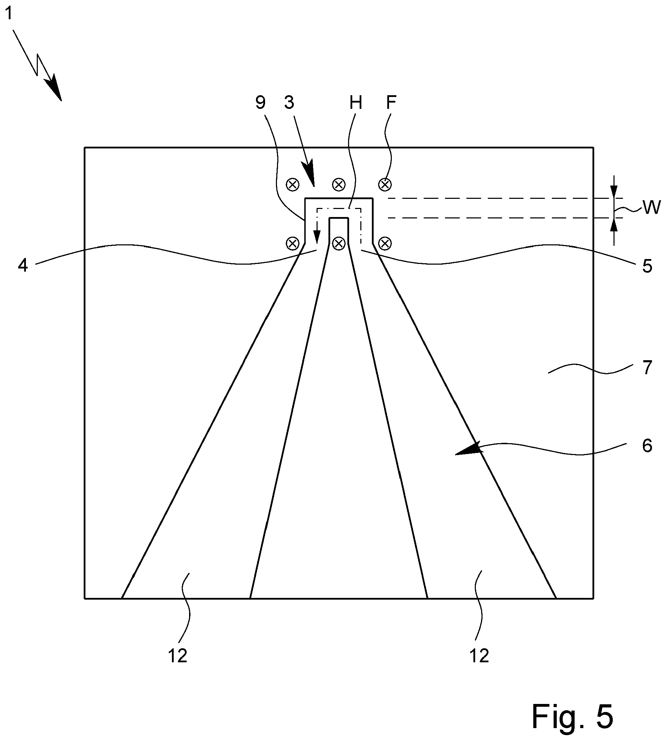

Fig. 5 zeigt in einer schematischen Draufsicht eine vorschlagsgemäße Vorrichtung 1 gemäß einer dritten Ausführungsform. Hierbei handelt es sich um die schematische Darstellung eines realisierten Versuchsaufbaus.

Auf einer unteren Schicht bzw. einem unteren Substrat oder Festkörper 7 ist eine Schicht 6 aufgebracht, die insbesondere ein Schichtsystem oder Schichtpaket bildet oder als solches aufgebaut ist.

Besonders bevorzugt ist der Aufbau der Schicht 6 bzw. des Schichtsystems entsprechend dem Versuchsaufbau folgendermaßen:
Eine Schicht aus einem ersten Halbleitermaterial, insbesondere GaAs, und eine Schicht aus einem zweiten Halbleitermaterial, insbesondere aus Al_{0,33}Ga_{0,67}As, sind übereinander geschichtet. Insbesondere sind diese Schichten mehrfach abwechselnd übereinander geschichtet, vorzugsweise mehr als 10 oder 20 mal, insbesondere zwischen 20 und 100 mal, beim Versuchsaufbau besonders bevorzugt 50 mal. So wird ein Schichtpaket gebildet.

Die Dicke D der einzelnen Schichten beträgt vorzugsweise weniger 50 nm, insbesondere weniger als 25 nm, besonders bevorzugt weniger als 10 nm, und ganz bevorzugt etwa 5 nm.

Das Schichtpaket ist optional und wird vorzugsweise auf einer Basisschicht oder Zwischenschicht, insbesondere aus GaAs und/oder mit einer Dicke von mehr als 100 nm, besonders bevorzugt mehr als 250 nm, ganz bevorzugt mit einer Dicke von etwa 500 nm, angeordnet.

Auf das Schichtpaket bzw. ein sonstiges Substrat wird vorzugsweise eine Deckschicht bzw. erste Schicht von vorzugsweise mehr als 500 nm, insbesondere mehr als 750 nm, besonders bevorzugt etwa 1000 nm, und/oder vorzugsweise aus GaAs aufgebracht.

Auf diese GaAs-Schicht wird vorzugsweise wiederum eine weitere bzw. zweite Schicht aus Al_{0,33}Ga_{0,67}As mit einer Dicke etwa 10 bis 50 nm, besonders bevorzugt etwa 35 nm aufgebracht. Vorzugsweise wird darüber wieder eine Schicht bzw. erste Deckschicht, insbesondere aus Al_{0,33}Ga_{0,67}As, insbesondere mit einer Silizium-Dotierung von vorzugsweise 1,5 · 10¹⁸ cm⁻³ und/oder mit einer Dicke von vorzugsweise mehr als 25 nm, insbesondere etwa 45 nm, aufgebracht.

Abschließend kann eine weitere Schicht bzw. Deckschicht aufgebracht sein, insbesondere aus GaAs, besonders bevorzugt mit einer Dicke von mehr als 10 nm, beim Versuchsaufbau von etwa 15 nm.

In dem Grenzbereich zwischen der ersten Schicht bzw. 1000 nm-Schicht, hier aus GaAs, und der zweiten Schicht bzw. 35 nm-Schicht, hier aus undotiertem Al_{0,33}Ga_{0,67}As, bildet sich vorzugsweise das zweidimensionale Elektronengas und der flächige Bewegungsbereich B.

Das vorgenannte Schichtsystem ist besonders bevorzugt auf die untere Schicht bzw. den unteren Festkörper 7 aufgebracht. Diese Schicht bzw. dieser Festkörper 7 besteht beim Versuchsaufbau besonders bevorzugt aus einem halbleitenden GaAs-Substrat.

Besonders bevorzugt ist beim Versuchsaufbau also folgendes Schichtsystem realisiert worden:

| **Name/Bezeichnung** | **Bevorzugte Zusammensetzung** | **Bevorzugte Dicke** |
|---|---|---|
| weitere Deckschicht | GaAs | 15 nm |
| erste Deckschicht | Al_{0,33}Ga_{0,67}As:Si 1,5 · 10¹⁸ cm⁻³ | 45 nm |
| zweite Schicht | Al_{0,33}Ga_{0,67}As | 35 nm |
| erste Schicht | GaAs | 1000 nm |
| mehrfach übereinander angeordnete dünne Schichten | GaAs | 5 nm |
| | Al_{0,33}Ga_{0,67}As | 5 nm |
| Zwischenschicht | GaAs | 500 nm |
| untere Schicht / Substrat | S-I GaAs | > 500 nm |

Die Schicht 6 bzw. das Schichtsystem bildet also ein zweidimensionales Elektronengas und dadurch einen Bewegungsbereich im bereits genannten Sinne, wie im Zusammenhang mit der ersten Ausführungsform beschrieben. Daher wird auf die Ausführungen und Erläuterungen zu der ersten Ausführungsform verwiesen, die insbesondere entsprechend oder ergänzend gelten.

Bei der Darstellung gemäß Fig. 5 liegt die Fläche bzw. Ebene E des Bewegungsbereichs B bzw. die Grenzfläche 8 innerhalb des Schichtsystems 6 in der Zeichenebene oder parallel dazu.

Bei der dritten Ausführungsform bildet die Leiteinrichtung 3 bzw. Schicht 6 bzw. das Schichtsystem vorzugsweise zwei sich verjüngende und/oder aufeinander zulaufende Schenkel 12, die die Anschlüsse 4 und 5 bilden bzw. zu diesen führen.

Insbesondere bildet die Schicht 6 bzw. das Schichtsystem die Leiteinrichtung 3 in Form eines hier einfach oder mehrfach, insbesondere zweifach, abgewinkelten Verlaufs. Insbesondere wird ein im Wesentlichen U-förmiger Verlauf in der Draufsicht bzw. in der Ebene des Bewegungsbereichs B bzw. für den Hauptweg H, wie in Fig. 5 angedeutet, gebildet.

Der Bewegungsbereich B bzw. die Leiteinrichtung 3 ist insbesondere auf den oberen U-förmigen Bereich der Schicht 6 bzw. den durch den Hauptweg H in Fig. 5 angedeuteten Bereich beschränkt.

Die mittlere Breite W des abgewinkelten bzw. U-förmigen Verlaufs bzw. Bewegungsbereichs B beträgt vorzugsweise mehr als 200 nm, insbesondere mehr als 500 nm, und/oder weniger als 9000 nm, insbesondere weniger als 7000 nm.

Beim Versuchsaufbau ergab sich eine mittlere Breite W von etwa 600 bis 650 nm. Der Zwischenraum im Bereich der beiden Anschlüsse 4 und 5 betrug beim Versuchsaufbau vorzugsweise etwa ebenfalls so viel wie die mittlere Breite W oder weniger.

Der vorschlagsgemäße Aufbau bzw. die vorschlagsgemäße Anordnung lässt sich insbesondere photolitographisch bzw. durch entsprechendes Ätzen oder alternativ durch Laserbearbeitung bzw. Laserabtrag verhältnismäßig einfach herstellen.

Vorzugsweise werden für das Schichtsystem unterschiedliche Halbleitermaterialien eingesetzt.

Beim Versuchsaufbau wurden für das Schichtsystem 6 insbesondere die den genannten Halbleitermaterialien eingesetzt und/oder mittlere freie Weglängen um 600 nm erreicht.

Das Feld F bzw. Magnetfeld verläuft vorzugsweise zumindest im Wesentlichen senkrecht zur Zeichenebene bzw. Ebene E, (nicht eingezeichnet) wie in Fig. 5 angedeutet.

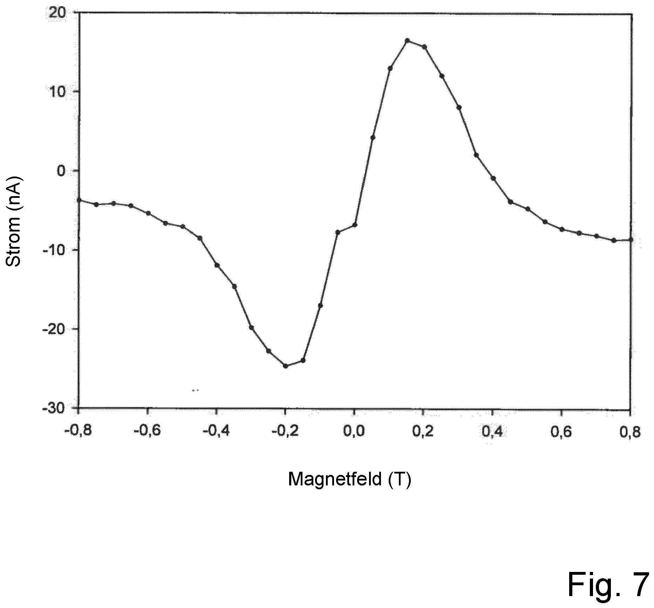

Bei dem vorschlagsgemäßen Versuchsaufbau wurde über die Schenkel 12 bzw. Anschlüsse 4 und 5 einerseits die Spannung und andererseits der Strom in Abhängigkeit von dem angelegten Magnetfeld bzw. der sich ergebenden magnetischen Flussdichte gemessen. Fig. 6 und 7 zeigen die sich ergebenden Diagramme bzw. Kurven.

Es ist deutlich aus Fig. 6 und 7 ersichtlich, dass sich jeweils bei etwa ± 0,2 T ein Extremwert bzw. Minimum und Maximum jeweils für die Spannung und für den Strom ergibt. Dies entspricht theoretischen Berechnungen bei dem hier realisierten mittleren Krümmungsradius R von etwa 600 nm. Die Messungen wurden bei Temperaturen unterhalb 20 K durchgeführt.

Die sich ergebenden Diagramme bzw. Messkurven sind - wie erwartet -symmetrisch zum Nullpunkt des Magnetfelds (genauer gesagt der magnetischen Flussdichte) und sind dadurch zu erklären, dass bei der magnetischen Flussdichte von etwa 0,2 T unter den genannten Versuchsbedingungen eine Führung der Ladungsträger zumindest im Wesentlichen entlang des Hauptwegs H, also innerhalb des gewünschten Bewegungsbereichs B bzw. der Leiteinrichtung 3, erfolgt, und zwar in Abhängigkeit von der Richtung des Magnetfelds einmal in die eine Richtung und einmal in die andere Richtung, so dass sich dementsprechend jeweils bei der Spannung und dem Strom entgegengesetzte Polaritäten bei etwa +0,2 T und -0,2 T ergeben.

Der in den Diagrammen gemäß Fig. 6 und 7 als Originalmessdaten sichtbare Offset erklärt sich alternativ oder zusätzlich aus elektrostatischen bzw. Peltier-Effekt bezogenen Störungen, die aber vom Magnetfeld unabhängig, also zum Magnetfeld invariant sind.

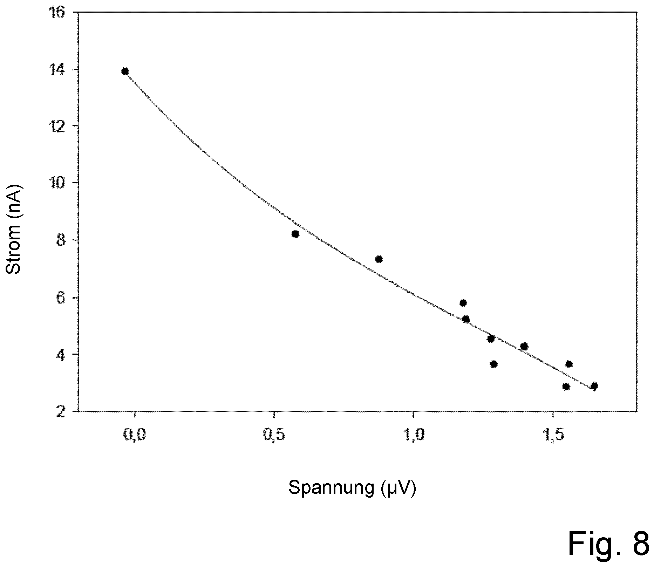

Fig. 8 zeigt eine mit der beschriebenen Versuchsanordnung bzw. Vorrichtung 1 gemessene Strom-/Spannungskennlinie äußerlich abgegriffen. Diese Kennlinie zeigt, dass mit der vorschlagsgemäßen Vorrichtung 1 elektrische Leistung erzeugbar bzw. von dieser abgebbar bzw. abgreifbar ist.

Dementsprechend ist mittels der vorschlagsgemäßen Versuchsanordnung bzw. Vorrichtung 1 also eine elektrische Spannung oder elektrische Leistung abgreifbar und aus der thermischen Energie der Ladungsträger 2 bzw. der Vorrichtung 1 bzw. Leiteinrichtung 3 und/oder aus dem elektromagnetischen Eigen- oder Umgebungsrauschen bzw. aus elektromagnetischer Einwirkung oder Einstrahlung erzeugbar bzw. bereitstellbar. Mit anderen Worten ist es also möglich, die Vorrichtung 1 zur Bereitstellung von elektrischer Energie bzw. Leistung durch den elektrischen Abgriff über die Anschlüsse 4 und 5 zu verwenden.

Alternativ oder zusätzlich ist es auch möglich, die Vorrichtung 1 zum Kühlen einzusetzen. Wenn nämlich elektrische Leistung über die Anschlüsse 4, 5 abgegriffen wird, wird den Ladungsträgern 2 bzw. der Vorrichtung 1 oder Leiteinrichtung 3 thermische Energie entzogen, so dass eine Kühlwirkung bzw. Temperaturverringerung erreicht werden kann.

Besonders bevorzugt ist die Felderzeugungseinrichtung 10 bzw. das Feld F zur Führung der Träger 2 steuerbar oder regelbar, um einen bestimmten oder gewünschten Wert der abgegriffenen elektrischen Spannung oder Leistung zu erreichen oder zu überschreiten oder um ein Maximum der abgegriffenen elektrischen Spannung oder Leistung zu erreichen.

Die vorschlagsgemäße Vorrichtung 1 bzw. das vorschlagsgemäße Prinzip ist, wie bereits erwähnt, universell einsetzbar.

Insbesondere kann die über die Anschlüsse 4, 5 abgegriffene Spannung auch zum Messen oder Bestimmen von sonstigen Eigenschaften, insbesondere dem Messen oder Bestimmen von Streuungen oder Bewegungsbahnen von Ladungsträgern 2 bei entsprechender Kalibrierung bzw. bei entsprechender Variation der jeweiligen Bedingungen, wie des Felds F, eingesetzt werden.

Weiter ist es auch möglich, physikalische Eigenschaften der Leiteinrichtung 3 bzw. des Bewegungsbereichs B bzw. der darin beweglichen Träger 2 durch Messung und Auswertung der über die Anschlüsse 4, 5 abgegriffenen elektrischen Spannung zu messen bzw. zu bestimmen. Dies gilt insbesondere, wenn ein ein- bzw. zweidimensionales Elektronengas oder ein Supraleiter als Leiteinrichtung 3 bzw. für den Bewegungsbereich B oder als (leitende) Schicht 11 eingesetzt wird.

Darüber hinaus ist die vorschlagsgemäße Vorrichtung 1 - jedoch ohne die Felderzeugungseinrichtung 10 - auch zum Messen von auf die Leiteinrichtung 3 einwirkenden Magnetfeldstärken bzw. magnetische Flussdichten einsetzbar, indem die elektrische Spannung über die Anschlüsse 4 und 5 gemessen wird. Bei entsprechender Kalibrierung ist dann dementsprechend die einwirkende magnetische Flussdichte sehr leicht feststellbar bzw. stimmbar. Die Vorrichtung 1 (ohne Felderzeugungseinrichtung 10) kann dann insbesondere als magnetischer Sensor angesehen bzw. eingesetzt werden.

Die vorschlagsgemäße Einrichtung 1 ist alternativ oder ergänzend auch zum Erfassen oder Messen von elektromagnetischem Eigen- oder Umgebungsrauschen (der Träger 2) und/oder einer elektromagnetischen Einwirkung bzw. Einstrahlung einsetzbar bzw. verwendbar.

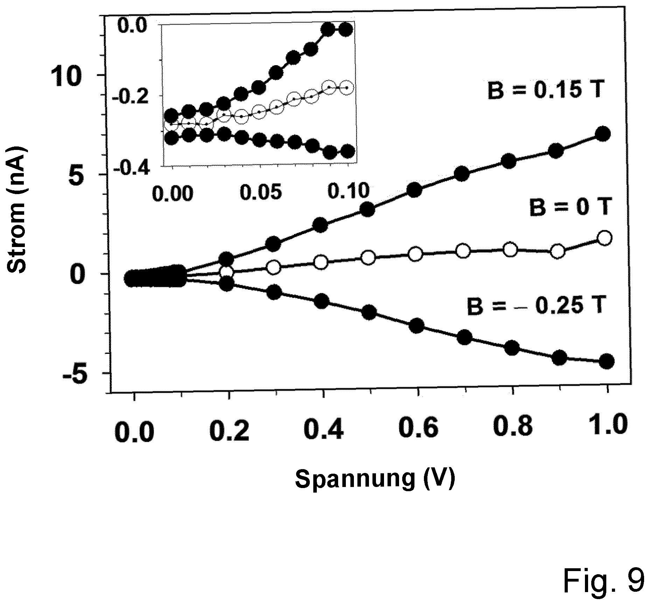

Fig. 9 zeigt das Ergebnis von Strom-Messungen, die an einem Versuchsaufbau im Sinne der Erfindung durchgeführt und über die Anschlüsse 4 und 5 abgegriffen bzw. gemessen wurden. Sie weist nach, wie robust der Effekt ungleicher Leitfähigkeit in die beiden von der Orientierung des Magnetfeldes abhängigen Richtungen ist. Bei diesem Versuch wurde an den Aufbau eine zusätzliche von außen kommende Wechselspannung zur Anregung im MHz-Bereich angelegt, und diese angelegte Spannung wurde über einen weiten Bereich von 0 bis ca. 1 V variiert.

Die Messung erfolgte bei etwa 10 K.

Mit einer Messreihe B = 0 T wurde die neutrale Kurve definiert, die den Strom ohne äußeres Magnetfeld, aber unter Einschluss aller anderer möglicher Störquellen (wie Ströme aufgrund von elektrochemischen Kontakten oder Thermospannungen) aufzeigt. Die Messreihe mit dem Magnetfeld B = + 0,15 T zeigt, dass die Leitfähigkeitsbevorzugung in die positive Stromrichtung über alle Anregungsfrequenzen positiv bleibt und der resultierende Strom annähernd proportional zur angelegten Wechselspannung ist. Die Messreihe mit dem Magnetfeld B = - 0,25 T zeigt ergänzend, dass die Leitfähigkeitsbevorzugung in die negative Stromrichtung über alle Anregungsfrequenzen negativ bleibt und der resultierende Strom ebenfalls annähernd proportional zur angelegten Wechselspannung ist. Insbesondere ist aber hervorzuheben, dass auch bei völliger Abwesenheit einer äußeren Anregung (also bei V = 0) noch ein positiver (bei B = + 0,15 T) bzw. negativer (bei B = - 0,25 T) Strom abweichend vom magnetfeldlosen Fall strömt (siehe Einschub bzw. Vergrößerung in Abb. 9). Dies ist der Nachweis dafür, dass sich aus dem Aufbau bzw. der erfindungsgemäßen Einrichtung 1 eine elektrische Dauerleistung äußerlich abgreifen lässt, die nicht aus dem Einfluss anderer möglicher Störquellen (wie Ströme aufgrund von elektrochemischen Kontakten oder Thermospannungen) stammt, sondern nur aus der thermischen Energie der Elektronen bzw. dem Eigen- oder Umgebungsrauschen.

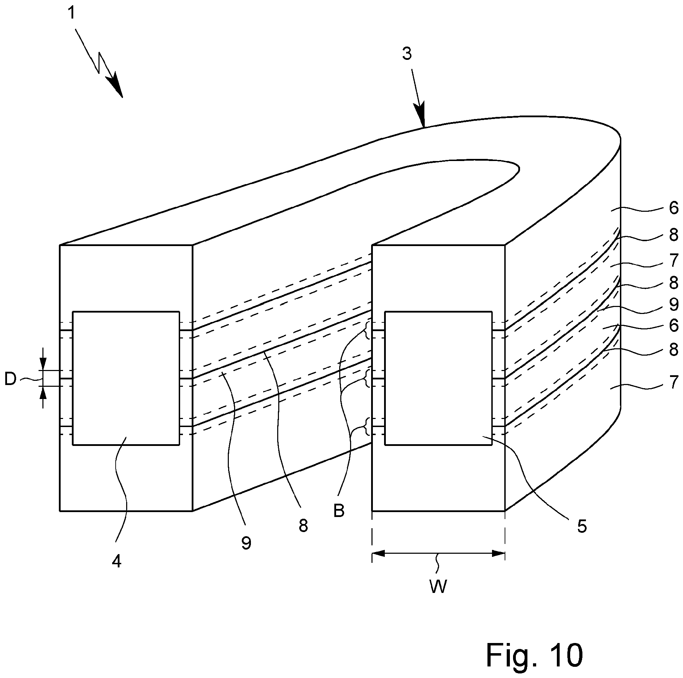

Fig. 10 zeigt in einer zu Fig. 1 korrespondierenden schematischen Darstellung eine fünfte Ausführungsform der vorschlagsgemäßen Vorrichtung 1 mit mehreren, insbesondere flachseitig übereinander geschichteten Bewegungsbereichen B bzw. Elektronengasen.

Die mehreren Bewegungsbereiche B sind vorzugsweise in oder von einer gemeinsamen Leiteinrichtung 3 gebildet.

Die mehreren Bewegungsbereiche B sind vorzugsweise parallel geschaltet und/oder über gemeinsame Elektroden 4, 5 angeschlossen.

Zwischen den verschiedenen Bewegungsbereichen B bzw. Elektronengasen können je nach Bedarf verschiedene Zwischen- oder Sperrschichten angeordnet oder gebildet sein.

Auch bei der fünften Ausführungsform gelten, genauso wie bei den anderen Ausführungsformen, die bisherigen Erläuterungen insbesondere entsprechend oder ergänzend, so dass diesbezügliche Wiederholungen unterbleiben.

Generell ist anzumerken, dass mittels der vorliegenden Erfindung bzw. der erfindungsgemäßen Vorrichtung 1 bzw. dem erfindungsgemäßen Verfahren eine asymmetrische oder richtungsabhängige Leitfähigkeit erzeugbar ist bzw. erzeugt wird und dementsprechend ein elektrischer Strom, eine elektrische Spannung und/oder eine elektrische Leistung abgegriffen bzw. bereitgestellt werden kann. Insbesondere wird eine Umwandlung von kinetischer oder thermischer Energie in elektrische Energie auf einfache bzw. effiziente und/oder direkte Weise ermöglicht.

Einzelne Aspekte und Merkmale der vorliegenden Erfindung bzw. verschiedenen Ausführungsformen können, wie bereits erwähnt, auch einzeln realisiert und beliebig kombiniert werden.

### Bezugszeichenliste:

- 1: Vorrichtung
- 2: Träger
- 3: Leiteinrichtung
- 4: Anschluss
- 5: Anschluss
- 6: Schicht / Festkörper
- 7: Schicht / Festkörper
- 8: Grenzfläche
- 9: Flanke
- 10: Felderzeugungseinrichtung
- 11: supraleitende Schicht
- 12: Schenkel

- B: Bewegungsbereich
- E: Ebene
- F: Feld
- H: Hauptweg
- R: Krümmungsradius
- Z: Zyklotronradius der Träger

## Patentansprüche

1. Vorrichtung (1) zur Führung von Trägern (2), die jeweils eine elektrische Ladung und/oder ein magnetisches Moment aufweisen,
mit einer Leiteinrichtung (3) zur beweglichen Führung der Träger (2) in einem Bewegungsbereich (B) mit einem gekrümmten oder abgewinkelten Hauptweg (H) für die Träger (2),
mit entlang des Hauptwegs (H) angeordneten elektrischen Anschlüssen (4, 5),
wobei die Vorrichtung (1) eine Felderzeugungseinrichtung (10) zur Erzeugung eines Felds (F) zur Führung der Träger (2) zumindest im Wesentlichen entlang des Hauptwegs (H) aufweist, so dass an den elektrischen Anschlüssen (4, 5) eine elektrische Spannung bzw. Leistung abgreifbar ist, wobei die Felderzeugungseinrichtung (10) bzw. das Feld (F) zur Führung der Träger (2) unter Berücksichtigung der Geschwindigkeit der Träger (2) so angepasst oder einstellbar bzw. steuerbar ist, dass die Träger (2) auf Bewegungsbahnen mit Krümmungsradien in der Größenordnung des Krümmungsradius (R) des Hauptwegs (H) geführt werden,
sich die Leiteinrichtung (3) bzw. der Bewegungsbereich (B) oder Hauptweg (H) zumindest im Wesentlichen in einer Ebene (E) oder entlang einer geschlossenen Fläche erstreckt und in dieser Ebene (E) bzw. Fläche gekrümmt bzw. abgewinkelt ist, und
die Flanke (9) bzw. Flanken (9) des Bewegungsbereichs (B) für die Träger (2) zumindest teilweise diffus streuend und/oder nicht ausschließlich spiegelnd ausgebildet ist bzw. sind.

2. Vorrichtung nach Anspruch 1, **dadurch gekennzeichnet, dass** die Leiteinrichtung (3) zwei insbesondere flachseitig aufeinanderliegende Schichten bzw. Festkörper (6, 7) mit unterschiedlichem Fermi-Niveau aufweist, wobei an bzw. entlang deren Grenzfläche (8) der Bewegungsbereich (B) gebildet ist.

3. Vorrichtung nach einem der voranstehenden Ansprüche, **dadurch gekennzeichnet, dass** die Leiteinrichtung (3) mehrere flachseitig übereinander liegende Bewegungsbereiche (B) aufweist oder bildet.

4. Vorrichtung nach einem der voranstehenden Ansprüche, **dadurch gekennzeichnet, dass** die mittlere Breite (W) des Bewegungsbereichs (B) und der Krümmungsradius (R) des Hauptwegs (H) zumindest im Wesentlichen der mittleren freien Weglänge der Träger (2) im Bewegungsbereich (B) entsprechen oder kleiner sind.

5. Vorrichtung nach einem der voranstehenden Ansprüche, **dadurch gekennzeichnet, dass** die Leiteinrichtung (3) bzw. der Bewegungsbereich (B) einfach oder mehrfach abgewinkelt und/oder zumindest bereichsweise bogenförmig oder halbkreisförmig gekrümmt ist.

6. Vorrichtung nach einem der voranstehenden Ansprüche, **dadurch gekennzeichnet, dass** der Krümmungsradius (R) der Leiteinrichtung (3) bzw. des Bewegungsbereichs (B) und/oder des Hauptwegs (H) mehr als 100 nm, insbesondere mehr als 200 nm, und/oder weniger als 2000 nm, insbesondere weniger als 1600 nm, beträgt.

7. Vorrichtung nach einem der voranstehenden Ansprüche, **dadurch gekennzeichnet, dass** die Felderzeugungseinrichtung (10) zur Erzeugung eines Magnetfelds (F) ausgebildet ist.

8. Verwendung einer Vorrichtung (1) nach einem der voranstehenden Ansprüche zum Erzeugen einer elektrischen Spannung oder Leistung aus der thermischen Energie bzw. Wärmeenergie von Ladungsträgern (2) und/oder aus dem elektromagnetischen Eigen- oder Umgebungsrauschen von Ladungsträgern (2), wobei die Spannung oder Leistung über die Anschlüsse (4, 5) abgegriffen wird.

9. Verwendung einer Vorrichtung (1) nach einem der Ansprüche 1 bis 7 zum Kühlen durch Entzug von thermischer Energie bzw. Wärmeenergie der Ladungsträger (2), indem elektrische Leistung über die Anschlüsse (4, 5) abgegriffen wird.

10. Verwendung einer Vorrichtung (1) nach einem der Ansprüche 1 bis 7 zum Messen oder Bestimmen von Streuungen oder Bewegungsbahnen von Ladungsträgern (2) und/oder zum Messen oder Erfassen einer elektromagnetischen Einstrahlung, indem eine elektrische Spannung über die Anschlüsse (4, 5) gemessen wird.

11. Verwendung nach einem der Ansprüche 8 bis 10, **dadurch gekennzeichnet, dass** das Feld (F) zumindest im Wesentlichen konstant gehalten wird.

12. Verwendung einer Vorrichtung (1) mit einer Leiteinrichtung (3) zur beweglichen Führung von Ladungsträgern (2), vorzugsweise Elektronen, zumindest im Wesentlichen in einem flächigen Bewegungsbereich (B) mit gekrümmten oder abgewinkelten Hauptwegen (H) und mit entlang der Hauptwege (H) angeordneten elektrischen Anschlüssen (4, 5),
wobei sich die Leiteinrichtung (3) bzw. der Bewegungsbereich (B) zumindest im Wesentlichen in einer Ebene (E) oder entlang einer geschlossenen Fläche erstreckt und in dieser Ebene (E) bzw. Fläche gekrümmt bzw. abgewinkelt ist,
wobei die Träger (2) an seitlichen Flanken (9) des Bewegungsbereichs (B) diffus streuend bzw. zumindest teilweise nicht spiegelnd reflektiert werden, und
wobei auf die Leiteinrichtung (3) einwirkende Magnetfeldstärken erfasst oder gemessen werden, indem eine elektrische Spannung über die Anschlüsse (4, 5) gemessen wird und daraus die einwirkende(n) Magnetfeldstärke(n) bestimmt wird bzw. werden.

## Claims

1. Device (1) for guiding carriers (2), each of which has an electrical charge and/or a magnetic moment,
with a guide device (3) for movably guiding the carriers (2) in a movement region (B) with a curved or angled main path (H) for the carriers (2),
with electrical connections (4, 5) arranged along the main path (H),
**characterized in**
**that** the device (1) has a field-generating means (10) for generating a field (F) for guiding the carriers (2) at least substantially along the main path (H), so that electrical voltage or power can be tapped at the electrical connections (4, 5), wherein the field-generating means (10) and/or the field (F) for guiding the carriers (2) is adapted or can be set and/or controlled in consideration of the speed of the carriers (2) such that the carriers (2) are guided on trajectories with radii of curvature on the order of magnitude of the radius of curvature (R) of the main path (H),
**that** the guide device (3) and/or the movement region (B) and/or main path (H) extends at least substantially in a plane (E) or along a closed surface and is curved and/or angled in this plane (E) or surface, and
**that** the flank (9) or flanks (9) of the movement region (B) for the carriers (2) are embodied so as to be at least partially diffusely scattering and/or not exclusively specular.

2. Device according to claim 1, **characterized in that** the guide device (3) has two layers or solid bodies (6, 7), lying particularly flat on top of one another, with different Fermi levels, with the movement region (B) and/or the two-dimensional electron gas being formed at or along the boundary surface (8) thereof.

3. Device according to any one of the preceding claims, **characterized in that** the guide device (3) has or forms several movement regions (B) and/or or electron gases and/or superconducting layers (11) lying flat on top of one another.

4. Device according to any one of the preceding claims, **characterized in that** the mean width (W) of the movement region (B) and the radius of curvature (R) of the main path (H) correspond at least substantially to or are less than the mean free path length of the carriers (2) in the movement region (B).

5. Device according to any one of the preceding claims, **characterized in that** the guide device (3) and/or the movement region (B) is singly or multiply angled and/or arcuate or semicircular at least in some areas.

6. Device according to any one of the preceding claims, **characterized in that** the radius of curvature (R) of the guide device (3) and/or of the movement region (B) and/or the main path (H) is greater than 100 nm, particularly greater than 200 nm, and/or less than 2000 nm, particularly less than 1600 nm.

7. Device according to any one of the preceding claims, **characterized in that** the field-generating means (10) is configured for generating a magnetic field (F).

8. Use of a device (1) according to any one of the preceding claims for generating electrical voltage or power from the thermal or heat energy from charge carriers (2) and/or from the electromagnetic inherent or ambient noise of charge carriers (2), with the voltage or power being tapped via the connections (4, 5).

9. Use of a device (1) according to any one of claims 1 to 7 for cooling through the removal of thermal or heat energy of the charge carriers (2) by tapping electrical power via the connections (4, 5).

10. Use of a device (1) according to any one of claims 1 to 7 for measuring or determining scattering or trajectories of charge carriers (2) and/or for measuring or detecting electromagnetic irradiation, by measuring electrical voltage via the connections (4, 5).

11. Use according to any one of claims 8 to 10 for measuring or determining physical properties within a one- or two-dimensional electron gas or superconductor.

12. Use of a device (1) with a guide device (3) for movably guiding charge carriers (2), preferably electrons, at least substantially in a laminar movement region (B) with curved or angled main paths (H) and with electrical connections (4, 5) arranged along the main paths (H),
wherein the guide device (3) and/or the movement region (B) extends at least substantially in a plane (E) or along a closed surface and is curved and/or angled in this plane (E) or surface,
wherein the carriers (2) are diffusely and/or at least partially not exclusively specularly scattered at lateral flanks (9) of the movement region (B), and
wherein magnetic field strengths acting on the guide device (3) are detected or measured by measuring an electrical voltage via the connections (4, 5) and determining the acting magnetic field strength(s) therefrom.

## Revendications

1. Dispositif (1) de guidage de porteurs (2), lesquels comportent respectivement une charge électrique et/ou un moment magnétique,
comprenant un moyen directeur (3) pour guider de manière mobile les porteurs (2) dans une zone de mouvement (B) comportant un trajet principal (H) incurvé ou coudé pour les porteurs (2),
comprenant des raccords (4, 5) électriques disposées le long du trajet principal (H),
**caractérisé en ce**
**que** ledit dispositif (1) comporte un dispositif générateur de champ (10) pour générer un champ (F) destiné au guidage des porteurs (2), au moins essentiellement le long du trajet principal (H), de telle sorte que, au niveau des raccords électriques (4, 5), une tension ou une puissance électrique puisse être prélevée, dans lequel le dispositif générateur de champ (10) ou le champ (F), pour le guidage des porteurs (2), en tenant compte de la vitesse des porteurs (2), peut être adapté ou réglé ou commandé de telle sorte que les porteurs (2) puissent être guidés sur des trajectoires de mouvement à des rayons de courbure de l'ordre du rayon de courbure (R) du trajet principal (H),
**que** le moyen directeur (3) ou la zone de mouvement (B) ou le trajet principal (H) s'étend, au moins essentiellement, dans un plan (E) ou le long d'une surface fermée et, dans ledit plan (E) ou dans ladite surface, est incurvé ou coudé et
**qu'**un flanc (9) ou des flancs (9) de la zone de mouvement (B) pour les porteurs (2) sont formés, au moins partiellement, dispersant de manière diffuse et/ou réfléchissant de manière non exclusive.

2. Dispositif selon la revendication 1, **caractérisé en ce que** le moyen directeur (3) comporte deux couches ou corps solides (6, 7), en particulier superposés côté plan, à différents niveaux de Fermi, dans lequel, au niveau ou le long de sa surface limite (8), la zone de mouvement (B) ou le gaz d'électrons bidimensionnel est formé.

3. Dispositif selon l'une quelconque des revendications précédentes, **caractérisé en ce que** le moyen directeur (3) comporte ou forme une pluralité de zones de mouvement (B) ou de gaz d'électrons ou de couches (11) supraconductrices superposés les uns sur les autres côté plan.

4. Dispositif selon l'une quelconque des revendications précédentes, **caractérisé en ce qu'**une largeur moyenne (W) de la zone de mouvement (B) et le rayon de courbure (R) du trajet principal (H), au moins sensiblement, correspondent ou sont inférieurs à une longueur de trajet libre moyenne du porteur (2) dans la zone de mouvement (B).

5. Dispositif selon l'une quelconque des revendications précédentes, **caractérisé en ce que** le moyen directeur (3) ou la zone de mouvement (B) est coudé de manière simple ou multiple et/ou, au moins par zones, en forme d'arc ou d'hémicycle.

6. Dispositif selon l'une quelconque des revendications précédentes, **caractérisé en ce que** le rayon de courbure (R) du moyen directeur (3) ou de la zone de mouvement (B) et/ou du trajet principal (H) est supérieur à 100 nm, en particulier supérieur à 200 nm et/ou inférieur à 2 000 nm, en particulier inférieur à 1 600 nm.

7. Dispositif selon l'une quelconque des revendications précédentes, **caractérisé en ce que** le dispositif générateur de champ (10) est conçu pour générer un champ magnétique (F).

8. Utilisation d'un dispositif (1) selon l'une quelconque des revendications précédentes pour générer une tension ou une puissance électrique à partir de l'énergie thermique ou de la chaleur des porteurs de charge (2) et/ou du bruit électromagnétique intrinsèque ou ambiant des porteurs de charge (2), dans laquelle la tension ou la puissance est prélevée par l'intermédiaire des raccords (4, 5).

9. Utilisation d'un dispositif (1) selon l'une quelconque des revendications 1 à 7 pour le refroidissement par absorption de l'énergie thermique ou de la chaleur des porteurs de charge (2) en ce que la puissance électrique est prélevée par l'intermédiaire des raccords (4, 5).

10. Utilisation d'un dispositif (1) selon l'une quelconque des revendications 1 à 8 pour mesurer ou pour déterminer la dispersion ou les trajectoires de mouvement des porteurs de charge (2) et/ou pour mesurer ou détecter un rayonnement électromagnétique, en ce qu'une tension électrique est mesurée par l'intermédiaire des raccords (4, 5), en particulier dans laquelle le champ (F) est maintenu au moins sensiblement constant.

11. Utilisation selon l'une quelconque des revendications 8 à 10 pour mesurer ou déterminer des propriétés physiques à l'intérieur d'un gaz électronique ou d'un supraconducteur unidimensionnel ou bidimensionnel.

12. Utilisation d'un dispositif (1) comprenant un moyen directeur (3) pour guider de manière mobile des porteurs de charges (2), de préférence des électrons, au moins essentiellement dans une zone de mouvement (B) plane comprenant des trajets principaux (H) incurvés ou coudés et comprenant des raccords (4, 5) électriques disposés le long des trajets principaux (H),
dans laquelle le moyen directeur (3) ou la zone de mouvement (B) s'étend, au moins essentiellement, dans un plan (E) ou le long d'une surface fermée et, dans ledit plan (E) ou dans ladite surface, est incurvé ou coudé,
dans laquelle les porteurs (2) étant réfléchis sur les flancs (9) latéraux de la zone de mouvement (B) de manière à être diffusément dispersés ou au moins partiellement non réfléchissants, et
dans laquelle des intensités de champ magnétique agissant sur le moyen directeur (3) sont détectées ou mesurées, en ce qu'une tension électrique est mesurée par l'intermédiaire des raccords (4, 5) et l'au moins une intensité de champ magnétique agissant est déterminée.
